# EUROPÄISCHE PATENTSCHRIFT

(11) **EP 0 903 859 B1**
(45) Veröffentlichungstag und Bekanntmachung des Hinweises auf die Patenterteilung: **24.11.2004**
(21) Anmeldenummer: 98116970.9
(22) Anmeldetag: 08.09.1998
(51) Int. Cl.: H03K 23/66, H03K 23/58

(54) **Frequenzteiler mit geringem Stromverbrauch**
Low-consumption frequency divider
Diviseur de fréquence à faible consommation

(30) Priorität: 18.09.1997 DE 19741210
(43) Veröffentlichungstag der Anmeldung: 24.03.1999
(73) Patentinhaber: Infineon Technologies AG, 81669 München (DE)
(72) Erfinder: Wilhelm, Wilhelm, Dr., 81477 München (DE); Knapp, Herbert, 80798 München (DE)
(74) Vertreter: Müller - Hoffmann & Partner

(56) Entgegenhaltungen:
- KASAHARA J ET AL: "10 GHZ GAAS JFET DUAL-MODULUS PRESCALER IC" ELECTRONICS LETTERS, Bd. 25, Nr. 14, 6. Juli 1989 (1989-07-06), Seite 889/890 XP000067419 ISSN: 0013-5194
- CRANINCKX J ET AL: "A 1.75-GHZ/3-V DUAL-MODULUS DIVIDE-BY-128/129 PRESCALER IN 0.7-MUM CMOS" IEEE JOURNAL OF SOLID-STATE CIRCUITS, Bd. 31, Nr. 7, 1. Juli 1996 (1996-07-01), Seiten 890-897, XP000632373 ISSN: 0018-9200
- PATENT ABSTRACTS OF JAPAN vol. 018, no. 270 (E-1552), 23. Mai 1994 (1994-05-23) & JP 06 045913 A (NEC CORP), 18. Februar 1994 (1994-02-18)

## Beschreibung

Die vorliegende Erfindung betrifft einen Frequenzteiler nach dem Oberbegriff des Patentanspruchs 1.

Unter dem Begriff Frequenzteiler sollen hier insbesondere sogenannte "Dual Modulus Prescaler" verstanden werden, wie sie in Frequenzsynthesizern von mobilen Telekommunikationssystemen Verwendung finden. Solche Frequenzteiler weisen zwischen 1/N und 1/(N+1) umschaltbare Teilungsfaktoren auf, wobei N typischerweise 64 oder 128 beträgt, arbeiten mit Frequenzen in der Größenordnung von 1 GHz und sind Bestandteil eines jeden GSM- oder DECT-Telefons. Wegen der üblicherweise vorhandenen Batterieversorgung der Geräte ist ein geringer Stromverbrauch von ganz wesentlicher Bedeutung.

Beispiele für die Verwendung und den Aufbau solcher Prescaler sind aus dem IEEE Journal of Solid-State Circuits, Vol. 29, No. 10, Oct. 1994, pp. 1206 bis 1211 sowie Vol. 27, No. 12, Dec. 1992, pp. 1794 bis 1798, bekannt, wobei jeweils einem synchronen 1:4/5-Teiler weitere asynchrone Teilererweiterungsstufen nachgeschaltet sind.

Aus Kasahara J et al.: '10 GHz Gaas Jfet Dual-Modulus Prescaler IC' Electronics Letters, Bd. 25, Nr. 14, 6. Juli 1989 (1989-07-06), Seite 889/890 XP000067419 ISSN: 0013-5194, ist ein Frequenzteiler mit einem eingangsseitigen Frequenzhalbierer bekannt, der aus einem Eingangssignal mit der Frequenz f ein erstes Zwischensignal bildet, das lediglich die Frequenz f/2 aufweist. Ein Zwischenteiler erzeugt aus dem ersten Zwischensignal abhängig von einem Umschaltsignal im Falle eines gewünschten Teilungsfaktors 1/N ein zweites Zwischensignal mit der Frequenz f/8 durch Herabsetzen der Frequenz mit dem Teilungsfaktor 1/4 und im Falle eines gewünschten Teilungsfaktors 1/(N+1) ein weiteres zweites Zwischensignal mit der Frequenz f/10 durch Herabsetzen der Frequenz mit dem Teilungsfaktor 1/5. Eine Teilererweiterungseinheit mit 2N-2 Teilerstufen liefert mit ihrer vorletzten Teilerstufe ein Ausgangssignal mit der Frequenz f/N bzw. f/(N+1), und eine Verknüpfungsschaltung erzeugt aus einem Steuersignal und einem Ausgangssignal der Teilererweiterungseinheit das Umschaltsignal.

Die der Erfindung zugrundeliegende Aufgabe besteht darin, einen Frequenzteiler der eingangs angegebenen Art anzugeben, der einen besonders geringen Stromverbrauch aufweist. Diese Aufgabe wird anhand der Merkmale des Patentanspruchs 1 gelöst. Der weitere Patentanspruch 2 betrifft eine vorteilhafte Ausgestaltung der Erfindung.

Im folgenden wird anhand der Zeichnung ein bevorzugtes Ausführungsbeispiel der Erfindung näher erläutert. Dabei zeigt
- Figur 1: ein Schaltbild eines beispielhaften Frequenzteilens und
- Figur 2: Zeitdiagramme zur Erläuterung der Funktionsweise der Schaltung nach Figur 1 und
- Figur 3: ein Schaltbild eines bevorzugten Ausführungsbeispiels.

Bei der Erfindung wird zunächst aus dem Eingangssignal IN mit der Frequenz f durch einen Frequenzhalbierer ein Zwischensignal mit der Frequenz f/2 gebildet, bevor dieses Signal, wie beim Stand der Technik, einem 1:4/5-Teiler zugeführt wird. Ferner wird das Ausgangssignal an Stelle einer letzten Stufe einer vorletzten Stufe eines Erweiterungsteilers als Ausgangssignal des Frequenzteilers verwendet. Dies hat zur Folge, daß nur ein Flipflop mit der maximalen Frequenz f = 1 GHz betrieben wird und somit eine deutliche Senkung des Gesamtstromverbrauches des Frequenzteilers erreicht werden kann. Da unter Umständen hierbei auf einen Vorverstärker zum Treiben der Taktleitungen des Zwischenteilers 4/5 verzichtet werden kann, führt dies zu einer weiteren Stromreduzierung.

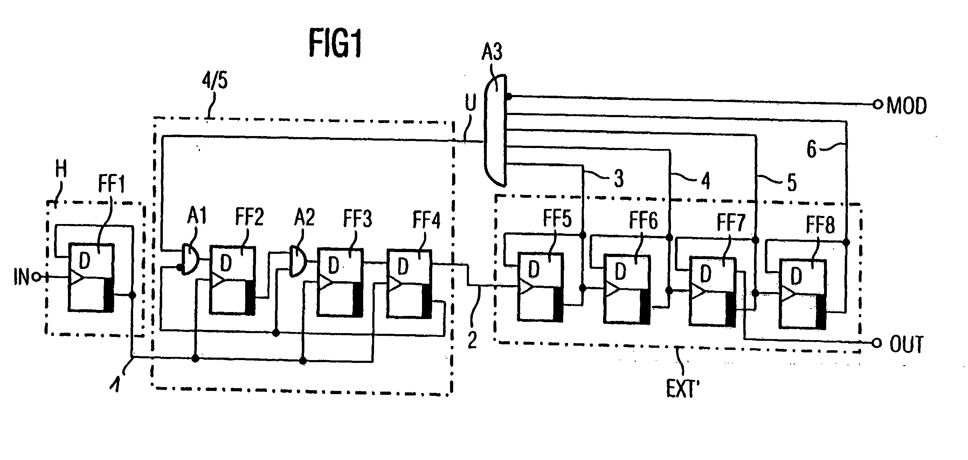

In Figur 1 ist beispielhaft ein Frequenzteiler für die Teilungsfaktoren 1/64 und 1/65 gezeigt, wobei dieser einen eingangsseitigen Frequenzhalbierer H, einen Zwischenteiler 4/5 und eine Teilererweiterung EXT aufweist. Der eingangsseitige Frequenzhalbierer H erzeugt aus einem Eingangssignal IN mit der Frequenz f ein Zwischensignal 1, das lediglich die Frequenz f/2 aufweist. Im Zwischenteiler 4/5 wird abhängig von einem Umschaltsignal U, im Falle eines gewünschten Teilungsfaktors 1/N ein zweites Zwischensignal 2 mit der Frequenz f/8 aus dem ersten Zwischensignal durch Herabsetzen der Frequenz mit dem Teilungsfaktor 1/4 und im Falle eines gewünschten Teilerungsfaktors 1/(N+1) das Zwischensignal 2 mit der Frequenz f/10 aus dem ersten Zwischensignal durch Herabsetzen der Frequenz mit dem Teilungsfaktor 1/5 erzeugt. Die Teilererweiterung EXT weist 2^{N-2} Teilerstufen (FF5 ... FF8) auf, deren vorletzte Teilerstufe FF7 ein Ausgangssignal OUT mit der Frequenz f/N bzw. f/(N + 1) liefert. Das Umschaltsignal U wird durch ein UND-Gatter A3 aus einem negierten Steuersignal MOD und aus den negierten Ausgangssignalen 3 ... 6 der Teilerstufen FF5 ... FF8 gebildet. Der Frequenzhalbierer ist hier derart ausgebildet, daß das Eingangssignal IN des Frequenzteilers als Taktsignal für ein D-Flipflop FF1 dient, dessen invertierter Eingang das Signal 1 führt und auf den D-Eingang rückgekoppelt ist. Der Zwischenteiler 4/5 enthält drei durch das Signal 1 synchron getaktete Flipflops FF2 ... FF4, wobei der D-Eingang des Flipflops FF2 mit einem UND-Gatter A1 verbunden ist, das das Umschaltsignal U mit dem zweiten Signal 2 verknüpft, wobei der D-Eingang des Flipflops FF3 mit einem UND-Gatter A2 verbunden ist, das ein negiertes Ausgangssignal des Flipflops FF2 mit einem negierten Ausgangssignal des Flipflops FF4 verknüpft, und wobei der nicht invertierte Ausgang des Flipflops FF3 mit dem D-Eingang des Flipflops FF4 verbunden ist. Die Flipflops FF5 ... FF8 der Teilererweiterung EXT sind hier als asynchroner Zähler geschaltet, wobei der Takteingang der D-Flipflops FF6 ... FF8 jeweils mit dem invertierten Ausgang der Vorgängenstufe verbunden ist und der Takteingang des Flipflops FF5 das Signal 2 erhält. Alle Flipflops FF1 ... FF8 sind D-Flipflops mit einem auf positive Signalflanken triggernden Takteingang. Durch die eingangsseitige Frequenzhalbierung entsteht am Ausgang der letzten Stufe des Erweiterungsteilers EXT eine Teilung durch 128 bzw. 130. Durch das Abgreifen des Ausgangssignals OUT am Ausgang der vorletzten Stufe des Erweiterungsteilers wird die gewünschte Teilung durch 64 bzw. 65 erreicht.

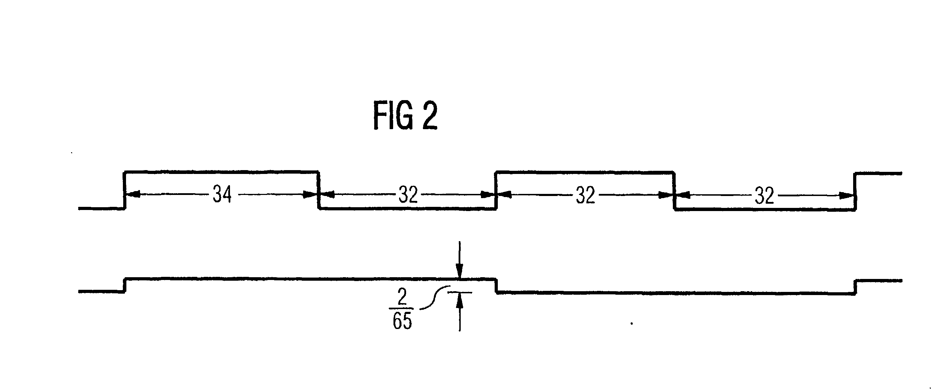

In Figur 2 ist das Ausgangssignal OUT der in Figur 1 gezeigten Schaltung dargestellt, wobei das Ausgangssignal dergestalt ist, daß nach 34 Perioden mit High-Pegel, 32 Perioden mit Low-Pegel, dann wieder 32 Perioden High-Pegel und schließlich wieder 32 Perioden Low-Pegel auftreten. Eine Analyse dieses Signals zeigt neben der gewünschten Grundwelle ein weiteres Signal der halben Ausgangsfrequenz und der Amplitude 2/65. Dies entspricht einer unerwünschten Überlagerung einer Störspannung (Jitter) mit der Frequenz der Grundwelle des Ausgangssignals.

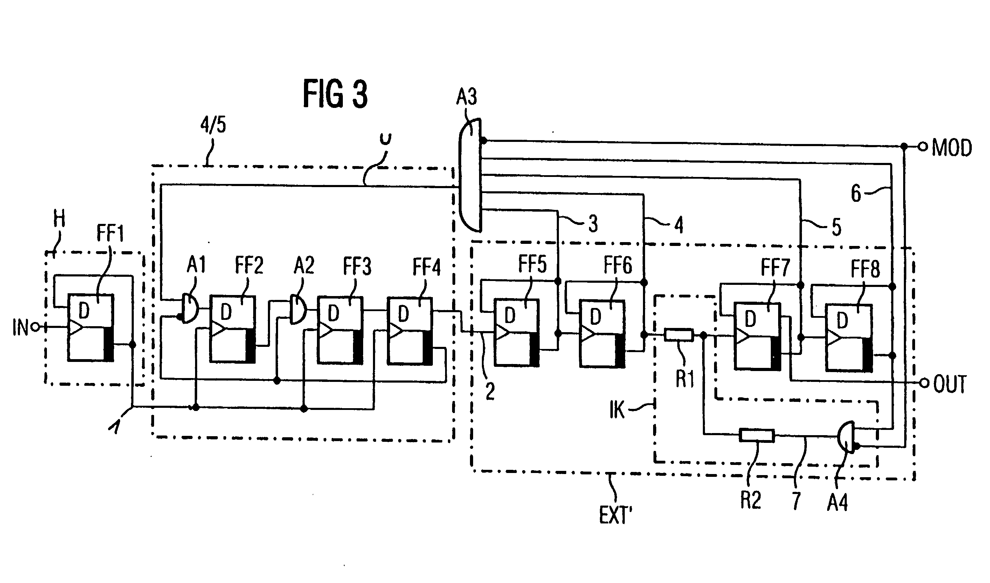

Zur Beseitigung dieses unerwünschten Jitters ist in Figur 3 ein bevorzugtes Ausführungsbeispiel der Erfindung angegeben, bei dem durch eine modifizierte Teilererweiterung EXT' mit einer Jitterkompensationseinrichtung JK ein Jitter am Ausgang OUT vermieden wird. Die Schaltung von Figur 3 entspricht bis auf die modifizierte Teilererweiterung EXT' anstelle der Teilererweiterung EXT der Schaltung von Figur 1. Die Jitterkompenstionseinrichtung JK besteht hier beispielsweise darin, daß das invertierte Ausgangssignal 4 des Flipflops FF6 über einen Widerstand R1 mit dem Takteingang des Flipflops FF7 verbunden ist und dem Takteingang des Flipflops FF7 über einen weiteren Widerstand R2 ein Signal 7 zugeführt wird, das durch eine UND-Verknüpfung (A4) des invertierten Ausgangssignals des Flipflops FF8 und des invertierten Steuersignals MOD gebildet wird. Hierdurch wird bewirkt, daß dem Signal 4 ein Signal mit der Amplitude - 2/65 mit der halben Frequenz des Ausgangssignals zugemischt und dadurch der Jitter beseitigt wird.

Bei einer geraden Anzahl von Teilererweiterungsstufen ist die Jitterkompensationseinrichtung (JK) allgeinen derart aufgebaut, daß nach der ersten Hälfte der Teilerstufen (FF5, FF6) ein vom Ausgangssignal der letzten Teilerstufe (FF8) abhängiges Signal (7) einem Taktsignal für eine erste Stufe (FF7) der zweiten Hälfte der Teilerstufen (FF7, FF8) aufaddiert wird.

## Patentansprüche

1. Frequenzteiler
- mit einem eingangsseitigen Frequenzhalbierer (H), der aus einem Eingangssignal (IN) mit der Frequenz f ein erstes Zwischensignal (1) bildet, das lediglich die Frequenz f/2 aufweist,
- mit einem Zwischenteiler (4/5), der, abhängig von einem Umschaltsignal (U), im Falle eines gewünschten Teilungsfaktors 1/N ein zweites Zwischensignal (2) mit der Frequenz f/8 aus dem ersten Zwischensignal durch Herabsetzen der Frequenz mit dem Teilungsfaktor 1/4 erzeugt und im Falle eines gewünschten Teilungsfaktors 1/(N+1) das Zwischensignal (2) mit der Frequenz f/10 aus dem ersten Zwischensignal durch Herabsetzen der Frequenz mit dem Teilungsfaktor 1/5 erzeugt,
- mit einer Teilererweiterung (EXT) mit 2^{N-2} Teilerstufen (FF5 ... FF8), deren vorletzte Teilerstufe (FF7) ein Ausgangssignal (OUT) mit der Frequenz f/N bzw. f/(N + 1) liefert und
- mit einer Verknüpfungsschaltung (A3), die aus einem Steuersignal (MOD) und Ausgangssignalen (3 ... 6) der Teilererweiterung das Umschaltsignal (U) erzeugt,
**dadurch gekennzeichnet, dass**
- die Teilererweiterung (EXT') eine Jitterkompensationseinrichtung (JK) derart aufweist, dass nach der ersten Hälfte der Teilerstufen (FF5, FF6) ein vom Ausgangssignal der letzten Teilerstufe (FF8) abhängiges Signal (7) einem Taktsignal für eine erste Stufe (FF7) der zweiten Hälfte der Teilerstufen (FF7, FF8) aufaddiert wird.

2. Frequenzteiler nach Anspruch 1,
- bei dem die Teilererweiterung (EXT') einen asynchronen Teiler mit vier Stufen (FF5 ... FF8) aufweist und
- bei dem die Jitterkompensationseinrichtung (JK) derart aufgebaut ist, dass ein Eingang der dritten Stufe (FF7) über einen ersten Widerstand (R1) mit einem Ausgang (4) der zweiten Stufe (FF6) und über einen zweiten Widerstand (R2) mit einem Ausgang (7) eines UND-Gatters (A4) verbunden ist, dessen erster Eingang mit einem Ausgang einer letzten Stufe (FF8) der Teilererweiterung verbunden ist und dessen zweiter Eingang mit dem invertierten Steuersignal (MOD) beschaltet ist.

## Claims

1. Frequency divider
- having an input-side frequency halver (H) which uses an input signal (IN) at the frequency f to form a first intermediate signal (1) whose frequency is only f/2,
- having an intermediate divider (4/5) which, as a function of a switching signal (U), produces a second intermediate signal (2) at the frequency f/8 from the first intermediate signal by dividing the frequency by the division factor 1/4 in the case of a desired division factor 1/N, and produces the intermediate signal (2) at the frequency f/10 from the first intermediate signal by dividing the frequency by the division factor 1/5 in the case of a desired division factor 1/(N+1),
- having a divider extension (EXT) with 2^{N-2} divider stages (FF5 ... FF8), whose penultimate divider stage (FF7) produces an output signal (OUT) at the frequency f/N or f/(N+1), and
- having a logic circuit (A3) which uses a control signal (MOD) and output signals (3 ... 6) from the divider extension to produce the switching signal (U),
**characterized in that**
- the divider extension (EXT') has a jitter compensation device (JK) such that, after the first half of the divider stages (FF5, FF6), a signal (7) which is dependent on the output signal from the last divider stage (FF8) is added to a clock signal for a first stage (FF7) of the second half of the divider stages (FF7, FF8).

2. Frequency divider according to Claim 1,
- in which the divider extension (EXT') has an asynchronous divider with four stages (FF5 ... FF8), and
- in which the jitter compensation device (JK) is designed such that one input of the third stage (FF7) is connected via a first resistor (R1) to one output (4) of the second stage (FF6) and via a second resistor (R2) to one output (7) of an AND gate (A4) whose first input is connected to one output of a last stage (FF8) of the divider extension, and whose second input is connected to the inverted control signal (MOD).

## Revendications

1. Diviseur de fréquence
- comprenant un diviseur (H) de la fréquence par 2 du côté de l'entrée, qui forme à partir d'un signal (IN) d'entrée ayant la fréquence f un premier signal (1) intermédiaire qui a seulement la fréquence f/2,
- comprenant un diviseur (4/5) intermédiaire qui en fonction d'un signal (U) de commutation, produit, dans le cas d'un facteur 1/N souhaité de division, un deuxième signal (2) intermédiaire ayant la fréquence f/8 à partir du premier signal intermédiaire par abaissement de la fréquence par le facteur de division 1/4, et dans le cas d'un facteur souhaité de division 1/(N+1), produit le signal (2) intermédiaire ayant la fréquence f/10 à partir du premier signal intermédiaire par abaissement de la fréquence par le facteur de division 1/5,
- comprenant un élargissement (EXT) de diviseur ayant 2^{N-2} étages (FF5 ... FF8) de diviseur, dont l'avant dernier étage (FF7) de diviseur fournit un signal (OUT) de sortie ayant la fréquence f/N ou f/(N+1), et
- comprenant un circuit (A3) de combinaison, qui produit, à partir d'un signal (MOD) de commande et de signaux (3 ... 6) de sortie de l'élargissement de diviseur, le signal (U) de commutation,
**caractérisé en ce que**
- l'élargissement (EXT') de diviseur comporte un dispositif (JK) de compensation de gigue de sorte, qu'après la première moitié des étages (FF5, FF6) de diviseur, un signal (7) qui dépend du signal de sortie du dernier étage (FF8) du diviseur, est ajouté à un signal d'horloge pour un premier étage (FF7) de la deuxième moitié des étages (FF7, FF8) de diviseur.

2. Diviseur de fréquence suivant la revendication 1,
- dans lequel l'élargissement (EXT') de diviseur comporte un diviseur asynchrone ayant quatre étages (FF5 ...FF8), et
- dans lequel le dispositif (JK) de compensation de gigue est constitué de façon à ce qu'une entrée du troisième étage (FF7) soit reliée par une première résistance (R1) à une sortie (4) du deuxième étage (FF6) et par une deuxième résistance (R2) à une sortie (7) d'une porte (A4), dont une première entrée est reliée à une sortie d'un dernier étage (FF8) de l'élargissement de diviseur et à une deuxième entrée de laquelle est appliqué le signal (MOD) de commande inversé.
